# EUROPÄISCHE PATENTANMELDUNG

(11) **EP 1 199 753 A2**
(43) Veröffentlichungstag der Anmeldung: **24.04.2002**
(21) Anmeldenummer: 01127563.3
(22) Anmeldetag: 13.09.1996
(51) Int. Cl.: H01L 31/0203, H01L 31/0232, H01L 33/00

(54) **Optoelektronisches Halbleiter-Bauelement**

(30) Priorität: 29.09.1995 DE 19536454
(62) Teilanmeldung aus: 96942999.2
(71) Anmelder: Osram Opto Semiconductors GmbH & Co. OHG, 93049 Regensburg (DE)
(72) Erfinder: Arndt, Karlheinz, 93059 Regensburg (DE); Brunner, Herbert, 93047 Regensburg (DE); Schellhorn, Franz, 93049 Regensburg (DE); Waitl, Günter, 93049 Regensburg (DE)
(74) Vertreter: Epping Hermann & Fischer

(57) **Zusammenfassung**

Strahlung aussendendes und/oder empfangendes Halbleiter-Bauelement, bei dem ein Strahlung aussendendes und/oder empfangendes Halbleiterchip (1) auf einem Chipträgerteil (2) eines Leiterrahmens befestigt ist. Der Chipträgerteil (2) bildet in dem Bereich, in dem das Halbleiterchip (1) befestigt ist, eine Wanne (4), deren Innenfläche (5) derart ausgebildet ist, daß sie einen Reflektor für die vom Halbleiterchip (1) ausgesandte und/oder empfangene Strahlung darstellt.

## Beschreibung

Die Erfindung bezieht sich auf ein Strahlung aussendendes und/oder empfangendes Halbleiter-Bauelement, bei dem ein Strahlung aussendendes und/oder empfangendes Halbleiterchip auf einem Chipträgerteil eines Leiterrahmens befestigt ist und bei dem das Halbleiterchip und mindestens ein Teilbereich des Chipträgerteiles von einer Umhüllung umgeben ist.

Ein solches Halbleiterbauelement ist beispielsweise aus der europäischen Patentanmeldung EP 400 176 bekannt. Darin ist eine sogenannte Top-LED beschrieben, bei der ein Halbleiterchip auf einem ebenen Chipträgerteil eines Leiterrahmens befestigt ist. Der Leiterrahmen setzt sich zusammen aus dem Chipträgerteil und einem getrennt von diesem angeordneten Anschlußteil mit jeweils einem externen Anschluß. Der Chipträgerteil mit dem Halbleiterchip, der Anschlußteil und Teilbereiche der externen Anschlüsse sind von einer Umhüllung umgeben, die aus aus einem strahlungsundurchlässigen Grundkörper mit einer Ausnehmung und einem diese Ausnehmung ausfüllenden strahlungsdurchlässigen Fensterteil besteht. Der Chipträgerteil und der Anschlußteil sind derart von dem Grundkörper umgeben bzw. in diesen eingebettet, daß Teilbereiche der Oberseiten des Chipträgerteils und des Anschlußteils mit der verbleibenden Bodenfläche der Ausnehmung bündig abschließen. Der Halbleiterchip ist bis auf seine Unterseite, mit der er auf dem Chipträgerteil aufliegt, vollständig von dem strahlungsdurchlässigen Fensterteil umgeben. Die Ausnehmung, die vollständig von dem strahlungsdurchlässigenn Fensterteil ausgefüllt ist, ist derart geformt, daß sie für die vom Halbleiterbauelement ausgesandte Strahlung einen Reflektor bildet.

Aus der EP-A-0 521 312 ist ein Strahlung aussendendes Halbleiterelement bekannt, das ein reflektierendes wannenförmiges Chipträgerteil aufweist, das von einer transparenten Umhüllung umschlossen ist. Weiterhin ist in der DE-A-42 32 644 ein optoelektronisches Halbleiterbauelement beschrieben, bei dem der Halbleiterchip an einem Trägerteil eines Leiterbandes befestigt ist, wobei dieses Trägerteil mit einer strahlungsundurchlässigen Umhüllung mit einer Ausnehmung für den Halbleiterchip versehen ist. Die Ausnehmung ist mit einer strahlungsdurchlässigen Umhüllung gefüllt.

Der Erfindung liegt die Aufgabe zugrunde, ein Strahlung aussendendes und/oder empfangendes Halbleiterbauelement der eingangs erwähnten Art so weiterzubilden, daß es eine erhöhte Strahlstärke aufweist und in einfacher Weise hergestellt werden kann. Gleichzeitig soll dieses Halbleiterbauelement eine gute Wärmeableitung vom Halbleiterchip aufweisen.

Diese Aufgabe wird durch ein Halbleiterbauelement mit den Merkmalen des Anspruches 1 gelöst.

Erfindungsgemäß ist bei dem Halbleiterbauelement nach Anspruch 1 vorgesehen, daß der Chipträgerteil in dem Bereich, in dem das Halbleiterchip befestigt ist, eine Wanne bildet, deren Innenfläche derart ausgebildet ist, daß sie einen Reflektor für die vom Halbleiterchip ausgesandte und oder empfangende Strahlung bildet und daß der Chipträgerteil wenigstens zwei externe elektrische Anschlüsse aufweist, die an verschiedenen Stellen der Umhüllung aus dieser herausragen.

Vorzugsweise ist bei dem Halbleiterbauelement vorgesehen, daß der Chipträgerteil in dem Bereich, in dem das Halbleiterchip befestigt ist, eine Wanne bildet, deren Innenfläche derart ausgebildet ist, daß sie einen Reflektor für die vom Halbleiterchip ausgesandte und oder empfangende Strahlung bildet und daß die Wanne des Chipträgerteiles zumindest teilweise aus der Umhüllung herausragt, derart, daß der Chipträgerteil im Bereich der Wanne elektrisch und/oder thermisch anschließbar ist.

Bei einer bevorzugten Ausführungsform des erfindungsgemäßen Halbleiterbauelements weist der Leiterrahmen das Chipträgerteil und ein in einem Abstand zum Chipträgerteil angeordneten Anschlußteil mit zwei externen Anschlüssen auf, die an gegenüberliegenden Seiten aus der Umhüllung herausragen.

Bei einer bevorzugten Weiterbildung des erfindungsgemäßen Halbleiterbauelements ist zumindest ein Teil der Innenflächen der Wanne des Chipträgers mit einem reflektionssteigernden Material beschichtet ist.

Bei einer vorteilhaften Ausführungsform des erfindungsgemäßen Halbleiterbauelements sind die externen Anschlüsse des Chipträgerteiles breiter als die externen Anschlüsse des Anschlußteiles.

Bei einer besonders bevorzugten Ausführungsform des erfindungsgemäßen Halbleiterbauelements weist die Umhüllung einen strahlungsundurchlässigen Grundkörper mit einer Ausnehmung und einen in der Ausnehmung angeordneten strahlungsdurchlässigen Fensterteil auf und umhüllt der strahlungsundurchlässige Grundkörper zumindest einen Teilbereich des Chipträgerteils, derart, daß zumindest die Wanne des Chipträgerteiles in der Ausnehmung angeordnet ist.

Bei einer vorteilhaften Weiterbildung dieser Ausführungsform verläuft die Oberkante der Wanne unterhalb der Oberkante der Ausnehmung und ist der Teilbereich der Innenfläche der Ausnehmung, die nicht von der Wanne bedeckt ist, derart ausgebildet, daß er für die vom Halbleiterchip ausgesandte Strahlung einen Reflektor bildet.

Bei einer weiteren vorteilhaften Weiterbildung des erfindungsgemäßen Halbleiterbauelements ist ein Teil der Innenflächen der Ausnehmung des strahlungsundurchlässigen Grundkörpers mit einem reflektionssteigernden Material beschichtet.

Weitere vorteilhafte Weiterbildungen der Erfindung sind Gegenstand von Unteransprüchen.

Die Erfindung wird anhand von drei Ausführungsbeispielen in Verbindung mit den Figuren 1a bis 3 näher erläutert. Es zeigen:
Figur 1a eine Draufsicht auf ein erstes Ausführungsbeispiel eines erfindungsgemäßen Halbleiterbauelements,
Figur 1b einen Schnitt durch das erste Ausführungsbeispiel entlang der in Figur 1a eingezeichneten Linie A - A,
Figur 1c einen Schnitt durch das erste Ausführungsbeispiel entlang der in Figur 1 a eingezeichneten Linie B - B,
Figur 2a eine Draufsicht auf ein zweites Ausführungsbeispiel eines erfindungsgemäßen Halbleiterbauelements,
Figur 2b einen Schnitt durch das zweite Ausführungsbeispiel entlang der in Figur 2a eingezeichneten Linie C - C,
Figur 3a einen Schnitt durch ein drittes Ausführungsbeispiel eines erfindungsgemäßen Halbleiterbauelements.

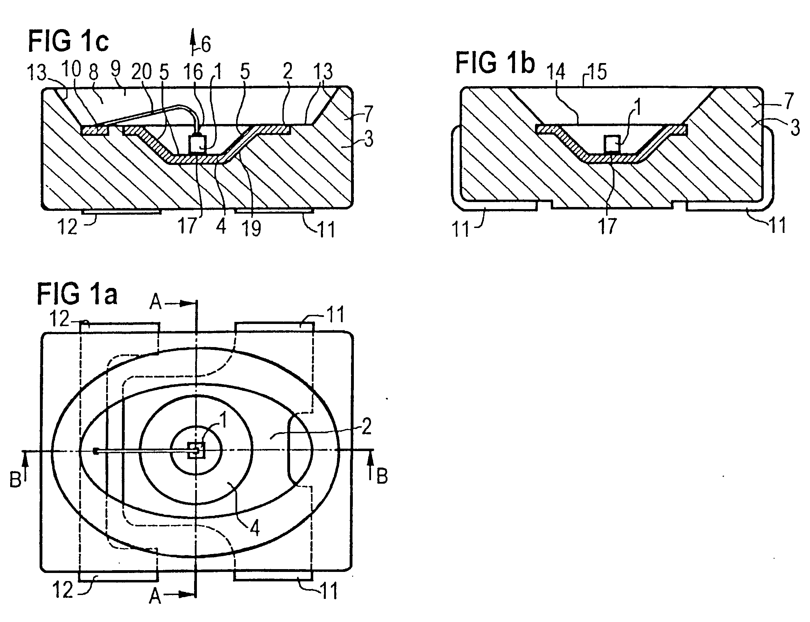

Bei dem Halbleiterbauelement der Figuren 1a bis 1c handelt es sich um eine sogenannte Top-LED in SMD-Bauweise. Diese setzt sich zusammen aus einem metallenen Leiterrahmen, bestehend aus einem Chipträgerteil 2 und einem Anschlußteil 10 mit jeweils zwei externen Anschlüssen 11, 12, einem auf dem Chipträgerteil 2 befestigten Strahlung aussendenden Halbleiterchip 1 und einer quaderförmigen Umhüllung 3. Der Halbleiterchip 1 weist an seiner Oberseite und an seiner Unterseite jeweils eine Kontaktmetallisierung 16, 17 auf. Die Kontaktmetallisierung 17 an der Unterseite ist beispielsweise mittels eines metallischen Lotes oder eines elektrisch leitenden Klebstoffes mit dem Chipträgerteil 2 und die Kontaktmetallisierung 16 an der Oberseite ist mittels eines Bonddrahtes 20, der z. B. aus Gold oder einem anderen geeigneten metallischen Werkstoff besteht, mit dem Anschlußteil 10 elektrisch leitend verbunden. In dem Chipträgerteil 2 ist in dem Bereich, in dem der Halbleiterchip 1 befestigt ist, beispielsweise mittels Prägen eine Wanne 4 ausgebildet, deren Innenfläche 5 annähernd die Form eines auf den Kopf gestellten Kegelstumpfes aufweist und für die vom Halbleiterchip 1 ausgesandte Strahlung einen Reflektor bildet. Die externen Anschlüsse 11, 12 des Chipträgerteiles 2 und des Anschlußteiles 10 ragen jeweils auf gegenüberliegenden Seiten aus dieser Umhüllung 3 heraus und sind außerhalb der Umhüllung 3 an der Umhüllung 3 entlang zunächst nach unten und anschließend nach innen in Richtung zur Mitte der Umhüllung 3 gebogen. Sie können jedoch auch jede beliebige andere Form aufweisen.

Die Umhüllung 3 ist zweiteilig aus einem strahlungsundurchlässigen Grundkörper 7 mit einer Ausnehmung 8 und einem diese Ausnehmung 8 ausfüllenden strahlungsdurchlässigen Fensterteil 9 gefertigt. Der Grundkörper 7 und der Fensterteil 9 besteht beispielsweise aus einem gefüllten Kunstharz oder aus einem Thermoplast bzw. aus einem transparenten Kunstharz oder Polycarbonat. Als Füllstoff für Kunstharz kommen beispielsweise Metallpulver, Metalloxide, Metallcarbonate oder Metallsilikate in Frage. Der Chipträgerteil 2 und der Anschlußteil 10 ist so von dem strahlungsundurchlässigen Grundkörper 7 umgeben bzw. in diesen eingebettet, daß ein Teilbereich des Anschlußteiles 10 und mindestens der Teilbereich des Chipträgerteiles 2, in dem sich die Wanne 4 befindet, auf der Bodenfläche 19 der Ausnehmung 8 aufliegt. Die Ausnehmung 8 weist eine größere Tiefe auf als die Wanne 4 auf, so daß die Wanne 4 vollständig innerhalb der Ausnehmung 8 angeordnet ist und deren Innenfläche 13 nach oben über die Wanne 4 hinausragt.

Bei einer bevorzugten Weiterbildung des ersten Ausführungsbeispieles ist die Innenfläche der Wanne 4 und evtl. auch der an das Fensterteil 9 angrenzende Teil der Oberseite des Anschlußteiles 10 zur Verbesserung der Reflexion poliert oder mit einem reflexionssteigernden Material beschichtet. Als reflexionssteigerndes Material eignet sich beispielsweise ein glänzender Lack oder Aluminium, das aufgedampft, aufgesputtert oder mittels eines anderen geeigneten Verfahrens aufgebracht wird. Ebenso können auch die nicht vom Chipträgerteil 2 und Anschlußteil 10 bedeckten Bereiche der Innenfläche 13 mit einer reflexionssteigernden Schicht versehen sein, so daß auch diese Bereich die vom Halbleiterchip 1 ausgesandte Strahlung in die vorgesehene Hauptstrahlrichtung 6 reflektieren. Hierzu eignet sich z. B. wiederum ein glänzender Lack oder Aluminium, das nach den oben genannten Verfahren aufgebracht wird.

Denkbar wäre auch, daß die Ausnehmung 8 nicht vollständig von dem Fensterteil 9 ausgefüllt ist, sondern daß nur der Halbleiterchip 1 und die Wanne 4 oder jeder andere beliebige Teilbereich der Ausnehmung 8 von dem Fensterteil umgeben bzw. bedeckt ist. Ebenso kann der Fensterteil 9 so gefertigt sein, daß dieser die Oberkante der Ausnehmung 8 hinausragt.

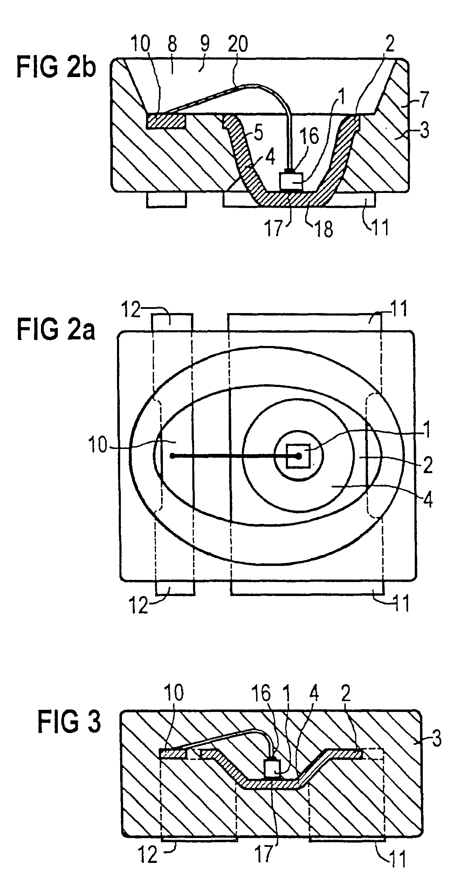

Zur Verbesserung der Wärmeableitung vom Halbleiterchip 1 können, wie in den Figuren 2a und 2b gezeigt, auch beim ersten Ausführungsbeispiel die externen Anschlüsse 11 des Chipträgerteiles 2 breiter sein als die externen Anschlüsse 12 des Anschlußteiles 10. Ebenso kann, falls notwendig bzw. möglich, vom Chipträgerteil 2 nur ein externer Anschluß 11 oder eine Mehrzahl (> 2) externer Anschlüsse 11 aus der Umhüllung herausgeführt sein. Das gleiche gilt für den Anschlußteil 10.

Bei einem möglichen Verfahren zur Herstellung des erfindungsgemäßen Halbleiterbauelements nach dem ersten Ausführungsbeispiel kann im Falle, daß der Grundkörper 7 aus einem Thermoplasten oder einem anderen temperaturstabilen Material besteht, der Leiterrahmen zunächst mit dem Grundkörpermaterial umhüllt werden, anschließend der Halbleiterchip und der Bonddraht befestigt werden und abschließend die Ausnehmung 8 mit dem Material des Fensterteiles 9 gefüllt werden.

Das in den Figuren 2a und 2b gezeigte zweite Ausführungsbeispiel unterscheidet sich von dem ersten Ausführungsbeispiel lediglich dadurch, daß der Chipträgerteil 2 derart in den Grundkörper 7 eingebettet ist, daß die Bodenwandung 18 der Wanne 4 auf der Unterseite des Grundkörpers aus diesem herausragt. Dadurch ist es möglich, den Chipträgerteil 2 direkt von außen zu kontaktieren, indem dieser beispielsweise direkt auf eine Leiterplatte geklebt oder gelötet wird. Darüber hinaus besitzen in diesem Ausführungsbeispiel die externen Anschlüsse 11 des Chipträgerteiles 2 eine größere Breite als die externen Anschlüsse 12 des Anschlußteiles 10 auf. Durch diese Maßnahmen, einzeln oder in Kombination, ist eine verbesserte Wärmeableitung vom Halbleiterchip 1 gewährleistet.

Sämtliche in Bezug auf das erste Ausführungsbeispiel oben genannten Weiterbildungen und Ausgestaltungen des erfindungsgemäßen Halbleiterbauelements können auch beim zweiten Ausführungsbeispiel realisierbar.

Das dritte Ausführungsbeispiel nach Figur 3 unterscheidet sich von dem vorgenannten ersten Ausführungsbeispiel dadurch, daß die Umhüllung 3 vollständig aus einem strahlungsdurchlässigen Material, beispielsweise ein transparentes Kunstharz, gefertigt ist. Auch in diesem Fall sind sämtliche im Zusammenhang mit dem ersten Ausführungsbeispiel genannten Ausgestaltungen denkbar.

Das vierte Ausführungsbeispiel weist bis auf den Unterschied, daß die Umhüllung vollständig aus einem transparenten Material gefertigt ist sämtliche Merkmale des zweiten Ausführungsbeispieles auf.

Die oben beschriebenen Ausführungsformen bzw. -beispiele des erfindungsgemäßen Halbleiterbauelements sind nicht nur auf die Verwendung eines Strahlung aussendenden Halbleiterchips 1 eingeschränkt sondern können ebenso für Photodioden-, Phototransistor- und andere Strahlung empfangende Halbleiterchips eingesetzt werden. Die Wanne 4 ist in diesem Fall so ausgebildet, daß die durch den Fensterteil 9 einfallende Strahlung in Richtung Halbleiterchip reflektiert wird.

## Patentansprüche

1. Strahlung aussendendes und/oder empfangendes Halbleiter-Bauelement, bei dem ein Strahlung aussendendes und/oder empfangendes Halbleiterchip (1) auf einem Chipträgerteil (2) eines Leiterrahmens befestigt ist, bei dem das Halbleiterchip (1) und mindestens ein Teilbereich des Chipträgerteiles (2) von einer Umhüllung (3) umgeben ist und bei dem der Chipträgerteil (2) in dem Bereich, in dem das Halbleiterchip (1) befestigt ist, eine Wanne (4) bildet, deren Innenfläche (5) derart ausgebildet ist, daß sie einen Reflektor für die vom Halbleiterchip (1) ausgesandte und/oder empfangene Strahlung bildet, **dadurch gekennzeichnet, daß** der Chipträgerteil (2) wenigstens zwei externe Anschlüsse (11) aufweist, die an verschiedenen Stellen der Umhüllung (3)aus dieser herausragen.

2. Halbleiterbauelement nach Anspruch 1, **dadurch gekennzeichnet, daß** der Leiterrahmen einen Chipträgerteil (2) und einen in einem Abstand zum Chipträgerteil (2) angeordneten Anschlußteil (10) mit zwei externen Anschlüssen (12) aufweist, die an gegenüberliegenden Seiten aus der Umhüllung (3) herausragen.

3. Halbleiterbauelement nach Anspruch 1 oder 2, **dadurch gekennzeichnet, daß** zumindest ein Teil der Innenflächen (5) der Wanne (4) des Chipträgers (2) mit einem reflektionssteigernden Material beschichtet ist.

4. Halbleiterbauelement nach Anspruch 2 oder 2 und 3, **dadurch gekennzeichnet, daß** die externen Anschlüsse (11) des Chipträgerteiles (2) breiter sind als die externen Anschlüsse (12) des Anschlußteiles (10).

5. Halbleiterbauelement nach einem der Ansprüche 1 bis 4, **dadurch gekennzeichnet, daß** die Umhüllung (3) vollständig aus einem strahlungsdurchlässigen Material besteht.

6. Halbleiterbauelement nach einem der Ansprüche 1 bis 4, **dadurch gekennzeichnet, daß** die Umhüllung (3) einen strahlungsundurchlässigen Grundkörper (7) mit einer Ausnehmung (8) und einen in der Ausnehmung (8) angeordneten strahlungsdurchlässigen Fensterteil (9) aufweist und daß der strahlungsundurchlässige Grundkörper (7) zumindest einen Teilbereich des Chipträgerteils (2) umhüllt, derart, daß zumindest die Wanne (4) des Chipträgerteiles (2) in der Ausnehmung (8) angeordnet ist.

7. Halbleiterbauelement nach Anspruch 6, **dadurch gekennzeichnet, daß** die Oberkante (14) der Wanne (4) unterhalb der Oberkante (15) der Ausnehmung (8) verläuft und daß der Teilbereich der Innenfläche (13) der Ausnehmung, die nicht von der Wanne (4) bedeckt ist, derart ausgebildet ist, daß er für die vom Halbleiterchip (1) ausgesandte Strahlung einen Reflektor bildet.

8. Halbleiterbauelement nach Anspruch 6 oder 7, **dadurch gekennzeichnet, daß** zumindest ein Teil der Innenflächen (13) der Ausnehmung (8) mit einem reflektionssteigernden Material beschichtet ist.
